(19) Europäisches Patentamt / European Patent Office / Office européen des brevets

(11) **EP 3 879 708 B1**

(12) **FASCICULE DE BREVET EUROPEEN**

(45) Date de publication et mention
de la délivrance du brevet:
**21.06.2023 Bulletin 2023/25**

(21) Numéro de dépôt: **21161926.7**

(22) Date de dépôt: **11.03.2021**

(51) Classification Internationale des Brevets (IPC):
**H03M 13/11** *(2006.01)*

(52) Classification Coopérative des Brevets (CPC):
**H03M 13/1108**

(54) **DÉCODAGE DES CODES LDPC AVEC BASCULEMENT DE BITS SÉLECTIF**

DEKODIERUNG VON LDPC-KODES MIT SELEKTIVER BIT-INVERSION

DECODING OF LDPC CODES WITH SELECTIVE BIT-FLIPPING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.03.2020 FR 2002431**

(43) Date de publication de la demande:
**15.09.2021 Bulletin 2021/37**

(73) Titulaire: **Commissariat à l'énergie atomique
et aux énergies alternatives
75015 Paris (FR)**

(72) Inventeur: **SAVIN, Valentin
38054 GRENOBLE CEDEX 9 (FR)**

(74) Mandataire: **Brevalex
56, Boulevard de l'Embouchure
B.P. 27519
31075 Toulouse Cedex 2 (FR)**

(56) Documents cités:
- CUI HANGXUAN ET AL: "An Improved Gradient Descent Bit-Flipping Decoder for LDPC Codes", IEEE TRANSACTIONS ON CIRCUITS AND SYSTEMS I: REGULAR PAPERS, IEEE, US, vol. 66, no. 8, 1 août 2019 (2019-08-01), pages 3188-3200, XP011733877, ISSN: 1549-8328, DOI: 10.1109/TCSI.2019.2909653 [extrait le 2019-07-02]
- ZHANG LI ET AL: "Tabu-List Noisy Gradient Descent Bit Flipping Decoding of LDPC Codes", 2019 11TH INTERNATIONAL CONFERENCE ON WIRELESS COMMUNICATIONS AND SIGNAL PROCESSING (WCSP), IEEE, 23 octobre 2019 (2019-10-23), pages 1-5, XP033671687, DOI: 10.1109/WCSP.2019.8927932
- TASNUVA TITHI ET AL: "Decoding LDPC codes via Noisy Gradient Descent Bit-Flipping with Re-Decoding", ARXIV.ORG, CORNELL UNIVERSITY LIBRARY, 201 OLIN LIBRARY CORNELL UNIVERSITY ITHACA, NY 14853, 31 mars 2015 (2015-03-31), XP081333375,
- CHANG TOFAR C-Y ET AL: "Multi-Stage Bit-Flipping Decoding Algorithms for LDPC Codes", IEEE COMMUNICATIONS LETTERS, IEEE SERVICE CENTER, PISCATAWAY, NJ, US, vol. 23, no. 9, 1 septembre 2019 (2019-09-01), pages 1524-1528, XP011745001, ISSN: 1089-7798, DOI: 10.1109/LCOMM.2019.2924210 [extrait le 2019-09-09]
- LI MAO-RUEI ET AL: "A modified gradient descent bit flipping decoding scheme for LDPC codes", 2017 IEEE INTERNATIONAL WORKSHOP ON SIGNAL PROCESSING SYSTEMS (SIPS), IEEE, 3 octobre 2017 (2017-10-03), pages 1-6, XP033257020, DOI: 10.1109/SIPS.2017.8109969
- SUNDARARAJAN GOPALAKRISHNAN ET AL: "Noisy Gradient Descent Bit-Flip Decoding for LDPC Codes", IEEE TRANSACTIONS ON COMMUNICATIONS, IEEE SERVICE CENTER, PISCATAWAY, NJ. USA, vol. 62, no. 10, 1 octobre 2014 (2014-10-01), pages 3385-3400, XP011561720, ISSN: 0090-6778, DOI: 10.1109/TCOMM.2014.2356458 [extrait le 2014-10-17]

- **DECLERCQ D ET AL: "Noise-aided gradient descent bit-flipping decoders approaching maximum likelihood decoding", 2016 9TH INTERNATIONAL SYMPOSIUM ON TURBO CODES AND ITERATIVE INFORMATION PROCESSING (ISTC), IEEE, 5 septembre 2016 (2016-09-05), pages 300-304, XP032981313, DOI: 10.1109/ISTC.2016.7593125**
- **TADASHI WADAYAMA ET AL: "Gradient descent bit flipping algorithms for decoding LDPC codes", IEEE TRANSACTIONS ON COMMUNICATIONS, IEEE SERVICE CENTER, PISCATAWAY, NJ. USA, vol. 58, no. 6, 1 juin 2010 (2010-06-01), pages 1610-1614, XP011310482, ISSN: 0090-6778, DOI: 10.1109/TCOMM.2010.06.090046**

**Description**

**DOMAINE TECHNIQUE**

La présente invention concerne de manière générale les codes LDPC (*Low Density Parity Check*) et plus particulièrement les méthodes de décodage dites de type GDBF (*Gradient Descent Bit Flipping*). Elle trouve notamment application dans les systèmes de communication ou d'enregistrement de données utilisant des codes LDPC.

**ÉTAT DE LA TECHNIQUE ANTÉRIEURE**

Les codes LDPC, initialement introduits par R. Gallager dans son article intitulé « Low density parity check codes » publié dans IEEE Trans. Inform. Theory, vol. IT-8, pages 21-28, 1962, sont désormais utilisés dans un grand nombre de normes de communication telles G.hn/G.9960 (norme ITU-T pour communications sur lignes électriques, lignes téléphoniques et câbles coaxiaux), IEEE 802.3an (10 Giga-bit/s Ethernet sur paire torsadée), IEEE 802.16e (norme WiMAX pour communications hyperfréquences), IEEE 802.11n-2009 (Wi-Fi standard), CMMB (China Multimedia Mobile Broadcasting), DVB-S2 / DVB-T2 / DVB-C2 (Digital Video Broadcasting, 2$^{nde}$ génération), DMB-T/H (Digital video broadcasting), DOCSIS 3.1 (Data Over Cable Service Interface Spécification), ou 5G-NR (New Radio, 5$^{ème}$ génération).

Un grand nombre de méthodes de décodage de codes LDPC sont connues de l'état de la technique. Une première méthode de décodage itératif, dite par inversion de bits ou BF (*Bit-Flipping*), originellement proposée par R. Gallager à titre d'exemple, est particulièrement simple mais ne permet pas d'obtenir de bonnes performances en termes de taux d'erreur en fonction du rapport signal à bruit. Elle a été rapidement supplantée par une méthode de décodage itératif dite à passages de messages ou MP (*Message-Passing*), renommée plus récemment méthode de décodage à propagation de croyance ou BP (*Belief Propagation*). Cette méthode fait appel à une représentation d'un code LDPC au moyen d'un graphe bipartite (graphe de Tanner), constitué de deux sous-ensembles disjoints, un premier sous-ensemble de noeuds étant associé aux bits du mot à décoder (dits noeuds de variable) et un second sous-ensemble de noeuds associés aux contraintes du code, (dits de noeuds de contrôle), typiquement des contrôles de parité. Le décodage est basé sur une séquence d'itérations, chaque itération faisant intervenir des échanges de messages aller et retour entre les noeuds de variable et les noeuds de contrôle du graphe. Plus précisément, un message transmis par un noeud de variable à un noeud de contrôle représente la « croyance » (*belief*) du noeud de variable quant à la valeur du bit codé correspondant. Réciproquement, le message transmis par un noeud de contrôle à un noeud de variable représente la « croyance » du noeud de contrôle quant à la valeur du bit codé correspondant au noeud de variable destinataire. En pratique, ces messages sont définis en termes de probabilités, ou de rapports de vraisemblance logarithmiques (LLR).

La méthode de décodage BP a donné lieu à de nombreuses variantes telles que les algorithmes de décodage « Sum-Product », « Min-Sum », « Min-Max », etc. Ces méthodes permettent d'obtenir de bonnes performances en termes de taux d'erreur en fonction du rapport signal sur bruit mais sont généralement gourmandes en ressources et temps de calcul.

L'émergence de besoins de communication à très haut débit et/ou à faible latence a suscité un regain d'intérêt pour les méthodes de décodage par inversion de bits. Récemment, une méthode de décodage BF particulièrement séduisante en raison de sa simplicité a été proposée dans l'article de T. Wadayama et al. intitulé « Gradient descent bit flipping algorithms for decoding LDPC codes » publié dans IEEE Trans. on Comm., vol. 58 No. 6, Juin 2010, pp. 1610-1614. Le décodage BF est formulé ici sous la forme d'un problème d'optimisation et le mot de code, solution de ce problème, est obtenu au moyen d'un algorithme de descente de gradient. Cette méthode de décodage, dénommée GDBF (*Gradient Descent Bit Flipping*) permet d'obtenir des performances sensiblement meilleures que la méthode de décodage BF de Gallager mais souffre néanmoins d'un inconvénient majeur inhérent aux algorithmes de descente de gradient lorsque la fonction de coût est hautement non-linéaire, à savoir que la solution obtenue n'est bien souvent qu'un minimum local. En d'autres termes, la méthode de décodage GDBF est sous-optimale au sens où elle peut ne fournir qu'un minimum local de la fonction coût (ou un maximum local de la fonction objectif). Ainsi, ses performances restent encore inférieures aux méthodes de décodage de type BP.

Différentes variantes de la méthode GDBF ont été proposées pour remédier à ce problème de sous-optimalité, notamment la méthode PGDBF (*Probabilistic GDBF*) et la méthode NGDBF (*Noisy GDBF*). Ces deux méthodes sont fondées sur le principe que l'ajout d'un bruit aléatoire dans la descente de gradient permet de sortir d'un optimum local. Comme nous le verrons plus loin, l'ajout de bruit aléatoire se fait au niveau de règle de décision d'inversion des bits les moins fiables.

Nous présenterons d'abord la méthode de décodage GDBF avant de présenter ses variantes PGDBF et NGDBF.

Nous considérons un code LDPC défini par son graphe de Tanner TG (ou de manière équivalente par sa matrice de parité **H**, les arêtes du graphe correspondant aux éléments non nuls de la matrice), ledit graphe comprenant $N$ noeuds de variable et $M$ noeuds de contrôle (chaque noeud de contrôle correspond à une équation de parité ou de manière équivalente à une ligne de la matrice **H**). On notera dans la suite $H(n)$ l'ensemble des noeuds de contrôle reliés au noeud de variable $n$ par une arête du graphe et $H(m)$ l'ensemble des noeuds de variable reliés au noeud de contrôle $m$.

Nous supposerons dans la suite que les symboles constitutifs d'un mot de code sont binaires et représentés par +1,-1, le bit « 0 » étant classiquement associé au symbole +1 et le bit « 1 » au symbole -1. Par exemple, le canal de transmission pourra être un canal binaire symétrique ou BSC (*Binary Symmetric Channel*) ou bien un canal binaire perturbé par un bruit additif blanc gaussien, dit AWGN (*Additive White Gaussian Noise*).

Un mot de code peut être représenté par un vecteur **x** de taille $N$, dont les éléments appartiennent à {+1,-1}, vérifiant les équations de parité, c'est-à-dire **Hx** = $(+1,+1,...,+1)^T$ avec les conventions précitées. On rappelle qu'un mot de code **x** est obtenu à partir d'un mot de d'information **a** par la relation **x=aG** où **G** est la matrice génératrice du code vérifiant la relation **H.G$^T$** = 0 où **G$^T$** est la transposée de la matrice **G** .

Si l'on note $y=(y_1,...,y_N)^T$ l'observable représentatif du mot à décoder (obtenu par exemple par démodulation du signal reçu ou bien lu d'un support d'enregistrement), le décodage au sens du maximum de vraisemblance (décodage ML) est équivalent à la recherche du mot de code **x** $=(x_1,...,x_N)^T$ présentant le maximum de corrélation avec le vecteur **y**.

La méthode de décodage GDBF définit pour ce faire une fonction-objectif, $E(x)$, dite aussi fonction d'énergie, par :

$$E\left(\mathbf{x}\right) \triangleq \alpha \sum_{n=1}^{N} x_n y_n + \sum_{m=1}^{M} \prod_{n \in H(m)} x_n \qquad (1)$$

Le premier terme de la fonction-objectif n'est autre que la corrélation (pondérée par le coefficient a> 0) entre le vecteur **x** et le signal reçu, le second terme représentant la somme des syndromes de **x**.Ce second terme est maximal et égal à $M$ lorsque **x** est un mot de code. Le coefficient multiplicatif $\alpha$ contrôle la contribution du terme de corrélation à la fonction-objectif. Si le vecteur **x*** qui maximise la fonction-objectif est un mot de code, celui-ci est nécessairement la solution du décodage au sens du maximum de vraisemblance.

L'approche proposée dans l'article de T. Wadayama précité consiste à maximiser la fonction-objectif $E(\mathbf{x})$ (ou, de manière équivalente, à minimiser la fonction de coût $-E(\mathbf{x})$ en utilisant une variante de l'algorithme de descente de gradient). Plus précisément, on utilise un algorithme itératif qui minimise la fonction de coût selon des directions successives. Pour ce faire, on introduit une fonction d'énergie locale $E_n(\mathbf{x})$, définie par :

$$E_n\left(\mathbf{x}\right) \triangleq \alpha x_n y_n + \sum_{m \in H(n)} \prod_{n' \in H(m)} x_{n'} \qquad (2)$$

Le premier terme est relatif à la corrélation selon l'axe de la coordonnée $x_n$, le second terme est une somme de syndromes portant sur tous les noeuds de variable, reliés au noeud de variable $x_n$ par une équation de parité.

Par souci de simplification, la fonction d'énergie locale $E_n$ (**x**) dans la direction $x_n$ sera notée dans la suite $E_n$. On définit à chaque itération de décodage un ensemble $F$ des bits peu fiables. Ces bits sont ceux dont l'énergie locale est inférieure à un seuil prédéterminé, $E_{th}$. Autrement dit, les bits faiblement corrélés avec le signal reçu et correspondant à une probabilité d'erreur importante sont sélectionnés comme devant être inversés. Plus précisément :

$$F \triangleq \left\{ x_v \middle| E_v \le E_{th} \right\} \qquad (3)$$

Lorsque le canal est un canal binaire symétrique (BSC), il a été proposé de prendre comme valeur de seuil :

$$E_{th} = \min_{n=1,...,N} \left(E_n\right) \qquad (4)$$

autrement dit, l'ensemble $F$ est alors constitué, à chaque itération, des bits minimisant la fonction d'énergie locale.

Alternativement, il a été proposé d'utiliser une valeur de seuil fixe ou adaptative, dépendant alors de l'indice de l'itération.

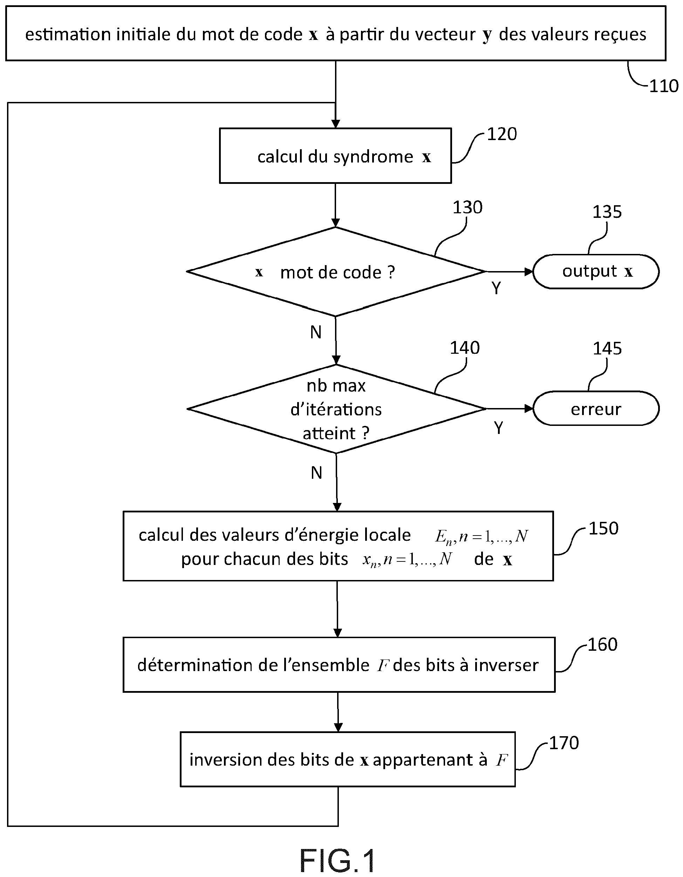

La Fig. 1 représente de manière schématique l'ordinogramme d'une méthode de décodage GDBF pour décoder un code LDPC.

Les principales étapes de la méthode de décodage y ont été récapitulées.

A l'étape 110, on effectue une première estimation du mot de code **x** à partir d'un observable **y** représentatif du mot à décoder. Par exemple, si le vecteur **y** a pour éléments des logarithmes de rapports de vraisemblance ou LLRs

$$y_n = \log \frac{\Pr\left(x_n = +1 \middle| r\right)}{\Pr\left(x_n = -1 \middle| r\right)}$$

(*Log Likelihood Ratios*), , n=1,...,N on pourra simplement estimer les éléments de **x** par $x_n$ = sgn($y_n$) où n =1,..., N et sgn($y_n$) est le signe de $y_n$ (sgn($y_n$)=+1 si $y_n$ >0 et sgn($y_n$)=-1 si $y_n$ < 0).

On entre ensuite dans une boucle de décodage itératif.

On effectue tout d'abord en 120 un calcul du syndrome de x, autrement dit de $\prod_{n\in H(m)} x_n$ , m=1,...,M.

On vérifie en 130 si le syndrome est nul, autrement dit ici si chacune des équations de parité est vérifiée :

$$\prod_{n\in H(m)} x_n = +1$$

, ∀m ∈ {1,...,M}.

Dans l'affirmative, l'algorithme de décodage s'arrête en fournissant le mot de code **x** en 135.

Dans la négative, on détermine en 140 si le nombre maximum d'itération est atteint. Si c'est le cas, l'algorithme s'arrête en 145 en fournissant une indication d'erreur.

En revanche si le nombre maximum d'itérations n'est pas atteint, on calcule les valeurs d'énergie locale $E_n$, n = 1,..,N en 150.

On en déduit, à l'étape 160, l'ensemble F des bits à inverser. Pour ce faire on détermine les bits dont les valeurs d'énergie locales sont inférieures à une valeur de seuil $E_{th}$, comme expliqué plus haut.

A l'étape 170, on inverse les bits de l'ensemble F, autrement dit $x_v = -x_v$ , ∀$x_v$ ∈ F puis l'on effectue une nouvelle itération en retournant à l'étape 120.

Comme on l'a indiqué précédemment, l'inconvénient de la méthode de décodage GDBF réside dans la présence d'un grand nombre d'extrema locaux (minima locaux de la fonction de coût ou maxima locaux de la fonction d'énergie). Le comportement du décodeur étant purement déterministe, il peut alors parcourir indéfiniment (en absence de critère d'arrêt portant sur le nombre d'itérations) une séquence d'extrema locaux voire rester bloqué sur l'un d'eux.

Les méthodes PGDBF et NGDBF remédient à cette difficulté en introduisant un mécanisme de randomisation dans la détermination des bits à inverser.

La méthode PGDBF a été décrite dans l'article de O. Al Rasheed et al. intitulé « Fault-tolerant probabilistic gradient-descent bit flipping décoder », publié dans IEEE Comm. Letters, vol. 18, no. 9, pp. 1487-1490, 2014.

Elle consiste, comme dans la méthode GDPF à déterminer, à chaque itération, l'ensemble F des bits dont l'énergie locale est inférieure à une valeur de seuil prédéterminée puis à inverser chacun des bits de F avec une probabilité 0 < p <1, p étant un paramètre de l'algorithme.

La méthode NGDBF a été décrite dans l'article de G. Sundararajan et al. intitulé « Noisy gradient descent bit-flip decoding for LDPC codes », publié dans IEEE Trans. on Comm., vol. 62, no. 10, pp. 3385-3400, 2014.

Dans cette méthode, la randomisation est introduite dans la détermination de l'ensemble F lui-même, celui-ci étant alors défini par :

$$F = \left\{x_v \middle| E_v + Z_v \le E_{th}\right\} \tag{5}$$

où $Z_v$ ~ N(0,$\sigma^2$) est une variable aléatoire gaussienne centrée et de variance $\sigma^2$, $\sigma^2$ étant un paramètre de l'algorithme.

Comme dans la méthode GDBF, tous les bits de F sont ensuite inversés.

Si les méthodes de décodage PGDBF et NGDBF présentent de meilleures performances de correction d'erreurs que la méthode de décodage GDBF en raison de leur capacité à sortir des extrema locaux, elles n'égalent cependant pas pour autant celles des méthodes de décodage de type à passage de messages (BP ou Min-Sum par exemple).

Une autre variante de méthode de décodage GDBF, dite TRGGDBF (*Tabu list Random penalty Gradient Descent Bit Flipping*) a été décrite dans l'article de H. Cui intitulé « An improved gradient descent bit-flipping décoder for LDPC codes » publié dans IEEE Trans. On Circuits and Systems, vol. 66, n° 8, 1.8.2019, pp. 3188-3200.

Les articles suivants concernent également les modifications et améliorations des méthodes de décodage de type GDBF. Dans l'article Zhang Li et al., "Tabu-List Noisy Gradient Descent Bit Flipping Decoding of LDPC Codes", Proc. 2019 11TH INTERNATIONAL CONFERENCE ON WIRELESS COMMUNICATIONS AND SIGNAL PROCESSING (WCSP), pages 1-5, afin d'augmenter la probabilité qu'un décodeur de type GDBF puisse échapper à un maximum local (ensemble de piégeage), une composante de bruit est ajoutée à la fonction d'énergie locale. En outre, une liste de "tabous" est introduite pour éviter que les bits ne soient inversés en deux itérations consécutives. L'article Tasnuva Tithi et al, "Decoding LDPC codes via Noisy Gradient Descent Bit-Flipping with Re-Decoding", ARXIV.ORG, CORNELL UNIVERSITY LIBRARY, propose aussi d'ajouter une composante de bruit à la fonction d'énergie locale du décodeur de type GDBF. De plus, une technique de redécodage est appliquée pour échapper aux ensembles de piégeage afin d'améliorer les performances du décodeur. L'article Chang Tofar C-Y et al, "Multi-Stage Bit-Flipping Decoding Algorithms for LDPC Codes", IEEE COMMUNICATIONS LETTERS, vol. 23, no. 9, propose d'appliquer le décodage par inversion de bit en plusieurs étapes pour casser les ensembles de piégeage. Dans la première étape, un décodage peu complexe comme par exemple un décodeur de type GDBF est appliqué. Si une boucle de décodage est détectée, alors le décodeur de Gallager original est appliqué dans la deuxième étape. L'article Li Mao-Ruei et al., "A modified gradient descent bit flipping decoding scheme for LDPC codes", Proc. 2017 IEEE INTERNATIONAL WORKSHOP ON SIGNAL PROCESSING SYSTEMS (SIPS), propose une autre modification du décodage de type GDBF, dans laquelle les positions des bits inversés sont enregistrées. Si une oscillation se produit pendant le décodage, le seuil de sélection des bits à inverser est abaissé et les bits précédemment inversés ne peuvent plus être inversés. Cela permet d'échapper aux maxima locaux. L'article Declercq et al., "Noise-aided gradient descent bit-flipping decoders approaching maximum likelihood decoding", Proc. 2016 9TH INTERNATIONAL SYMPOSIUM ON TURBO CODES AND ITERATIVE INFORMATION PROCESSING (ISTC), concerne l'amélioration du décodage de type GDBF par l'utilisation d'un ordonnancement modifié. Les valeurs d'énergie calculées à l'itération précédente sont évaluées pour effectuer une inversion des bits à l'itération actuelle. Cela permet d'atténuer les effets des ensembles de piégeage. Dans l'article Sundararajan Gopalakrishnan et al., "Noisy Gradient Descent Bit-Flip Decoding for LDPC Codes", IEEE TRANSACTIONS ON COMMUNICATIONS, vol. 62, no. 10, plusieurs modifications et variantes du décodage de type GDBF sont proposées. Dans la section III.C, un troisième terme est ajouté à la fonction d'énergie locale, qui est une composante du bruit. En outre, la fonction d'énergie locale comprend un facteur de pondération du syndrome. Dans la section III.D, le seuil de décision est rendu adaptatif. Si un bit n'est pas inversé, le seuil est alors diminué pour le bit correspondant.

Le but de la présente invention est par conséquent de proposer une méthode de décodage de type GDBF, randomisée ou non, qui permette de décoder un code LDPC avec des performances de correction d'erreurs qui soient proches de celles des méthodes de décodage à passage de messages voire meilleures que ces dernières, sans être sensiblement plus complexe que les méthodes de décodage de type GDBF.

## EXPOSÉ DE L'INVENTION

La présente invention est définie par une méthode de décodage d'un code LDPC représenté par un graphe de Tanner comprenant $N$ noeuds de variable et $M$ noeuds de contrôle, chaque noeud de contrôle étant associé à une contrainte de parité portant sur une pluralité de noeuds de variable, ladite méthode de décodage opérant sur un observable (y) représentatif du mot à décoder et procédant par itérations successives, chaque itération opérant sur un mot estimé (x) et, si le mot estimé n'est pas un mot du code, déterminant un ensemble ($\tilde{F}$) des bits les moins fiables de ce mot pour être inversés avant l'itération suivante, les bits les moins fiables du mot estimé étant déterminés comme ceux dont la valeur d'une fonction d'énergie locale ($\tilde{E}_n$) est inférieure à une valeur de seuil, la fonction d'énergie locale d'un bit comprenant une première composante proportionnelle à la corrélation entre ce bit et un élément correspondant de l'observable, une deuxième composante représentative du nombre de contraintes non vérifiées dans lesquelles intervient ledit bit, ladite méthode étant originale en ce que la fonction d'énergie locale comprend en outre une troisième composante, dite composante inertielle, décroissant avec le nombre ($\ell_n$) d'itérations effectuées depuis la dernière inversion de ce bit.

Selon un premier mode de réalisation, chaque bit de l'ensemble ($\tilde{F}$) des bits les moins fiables est inversé avant l'itération suivante.

Selon un deuxième mode de réalisation, chaque bit de l'ensemble ($\tilde{F}$) des bits les moins fiables est inversé avec une probabilité $p$ prédéterminée, $0 < p < 1$, avant l'itération suivante.

Selon un troisième mode de réalisation, pour déterminer l'ensemble ($\tilde{F}$) des bits les moins fiables, on ajoute un bruit aléatoire de variance prédéterminée ($\sigma^2$) à la valeur de la fonction d'énergie locale ($\tilde{E}_n$) avant la comparaison avec ladite valeur de seuil.

Avantageusement, la valeur de seuil est déterminée à partir de la valeur minimale de la fonction d'énergie locale sur les bits du mot estimée, augmentée d'une marge $\delta \geq 0$ prédéterminée.

Ladite valeur de seuil peut être adaptative et fonction du nombre total d'itérations effectuées depuis le début du décodage.

De préférence, la composante inertielle de la fonction d'énergie locale d'un bit est une fonction linéaire décroissante du nombre d'itérations effectuées depuis la dernière inversion de ce bit.

Alternativement, la composante inertielle de la fonction d'énergie locale d'un bit est une fonction linéaire définie par morceaux.

De préférence, la composante inertielle de la fonction d'énergie locale d'un bit est nulle au-delà d'une valeur $L$ prédéterminée.

Dans ce dernier cas, dans une étape d'initialisation, le nombre $\ell_n$ représentant le nombre d'itérations effectuées depuis la dernière inversion d'un bit pourra être initialisé à une valeur $\ell_{max} \geq L$, ce nombre étant mis à zéro dès lors que ce bit est inversé, et incrémenté à chaque itération jusqu'à atteindre ladite valeur $L$.

**BRÈVE DESCRIPTION DES DESSINS**

D'autres caractéristiques et avantages de l'invention apparaîtront à la lecture d'un mode de réalisation préférentiel de l'invention, décrit en référence aux figures jointes parmi lesquelles :

La Fig. 1 représente de manière schématique un ordinogramme d'une méthode de décodage GDBF pour décoder un code LDPC, connue de l'état de la technique ;

La Fig. 2 représente de manière schématique un ordinogramme d'une méthode de décodage d'un code LDPC selon un mode de réalisation de la présente invention ;

Les Figs. 3A et 3B illustrent les performances de méthodes de décodage de type GDBF connues de l'état de la technique et d'une méthode de décodage selon un mode de réalisation de la présente invention, dans le cas d'un canal binaire symétrique, respectivement pour un premier et pour un second exemple de code LDPC ;

Les Figs. 4A et 4B illustrent les performances de méthodes de décodage de type GDBF connues de l'état de la technique et d'une méthode de décodage selon un mode de réalisation de la présente invention dans le cas d'un canal AWGN, respectivement pour un premier et pour un second exemple de code LDPC.

**EXPOSÉ DÉTAILLÉ DE MODES DE RÉALISATION PARTICULIERS**

Nous considérerons dans la suite une méthode de décodage GDBF d'un code LDPC, sous la forme d'une variante randomisée telle que PGDBF ou NGDBF, comme décrit dans la partie introductive.

L'idée à la base de l'invention est d'adjoindre une composante inertielle à la fonction d'énergie locale. Cette composante a pour objet de réduire la probabilité qu'un bit soit inversé s'il a déjà été récemment inversé lors d'une itération précédente. En d'autres termes, on introduit un effet d'inertie obligeant l'algorithme de décodage itératif à rechercher le maximum de la fonction d'énergie en conservant une certaine cohérence directionnelle. Cette composante permet d'éviter des oscillations entre des positions correspondant à des extrema locaux.

Plus précisément, la nouvelle fonction d'énergie peut s'exprimer sous la forme, en conservant les notations précédentes :

$$\tilde{E}_n(\mathbf{x}) \triangleq \alpha x_n y_n + \sum_{m \in H(n)} \prod_{n' \in H(m)} x_{n'} + \rho(\ell_n) \qquad (6)$$

où $\ell_n \geq 1$ est défini comme le nombre d'itérations depuis la dernière inversion du bit $x_n$ et $\rho(\ell_n)$ est la composante inertielle qui est associée à $\ell_n$. Ainsi, $\ell_n = 1$ si le bit $x_n$ a été inversé à la dernière itération, $\ell_n = 2$ s'il a été inversé à l'avant-dernière itération, etc. Dans la suite, la fonction d'énergie locale dans la direction de $x_n$ sera plus simplement notée $\tilde{E}_n$.

On suppose que la composante inertielle précitée a un effet mémoire limité à un nombre prédéterminé $L$ d'itérations. Elle peut être représentée par conséquent sous la forme d'un vecteur $\rho$ de taille $L$, soit $\rho = (\rho(1),\rho(2),...,\rho(L))$, avec $\rho(1) \geq \rho(2) \geq ... \geq \rho(L) > 0$, étant entendu que $\rho(\ell_n) = 0$ pour $\ell_n > L$.

Au début du décodage, le nombre $\ell_n$ d'itérations depuis la dernière inversion du bit, $x_n$, est initialisé à $L + 1$, ce pour $n = 1,...,N$. Si le bit $x_n$ est inversé lors d'une itération, le nombre $\ell_n$ correspondant est mis à zéro. Il est systématiquement incrémenté de 1 au début de chaque itération sans pour autant pouvoir excéder la valeur maximale, $L+1$. Autrement dit, si le bit $x_n$ a été inversé à l'itération précédente, la valeur $\ell_n = 1$ est prise en compte à l'itération courante pour le calcul de la fonction d'énergie locale.

Selon un premier mode de réalisation de l'invention, on détermine au terme de de chaque itération du décodage itératif, un ensemble $\tilde{F} \triangleq \left\{ x_v \middle| \tilde{E}_v \leq \tilde{E}_{th} \right\}$ de bits peu fiables où $\tilde{E}_{th}$ est une valeur de seuil fixe ou adaptative, déterminée comme précisé plus loin. Les bits de $\tilde{F}$ sont ensuite inversés en préparation de l'itération suivante.

Selon un deuxième mode de réalisation de l'invention, correspondant à la variante PGDBF, chaque bit de $\tilde{F}$ est inversé de manière aléatoire, avec une probabilité $0 < p < 1$ où $p$ est un paramètre de l'algorithme. En d'autres termes, pour chaque bit appartenant à $\tilde{F}$, on effectue un tirage d'une variable aléatoire $u$, par exemple équirépartie sur l'intervalle [0,1], le bit en question étant inversé si $u < p$ et étant maintenu inchangé sinon.

Selon un troisième mode de réalisation de l'invention, correspondant à la variante NGDBF, l'ensemble $\tilde{F}$ des bits peu fiables est randomisé, soit $\tilde{F} \triangleq \left\{ x_v \middle| \tilde{E}_v + Z_v \leq \tilde{E}_{th} \right\}$ où $Z_v \sim N(0,\sigma^2)$ est une variable aléatoire gaussienne centrée et de variance $\sigma^2$, $\sigma^2$ étant un paramètre de l'algorithme. En d'autres termes, à chaque valeur d'énergie d'un bit on ajoute un échantillon de bruit aléatoire, par exemple d'un bruit gaussien centré de variance $\sigma^2$, la valeur d'énergie ainsi bruitée étant comparée à ladite valeur de seuil. De manière équivalente, la valeur d'énergie de chaque bit est comparée à l'échantillon d'une variable aléatoire gaussienne centrée sur $\tilde{E}_{th}$ et de variance $\sigma^2$, un échantillon étant tiré à chaque bit. On choisira typiquement $\sigma \ll \tilde{E}_{th}$.

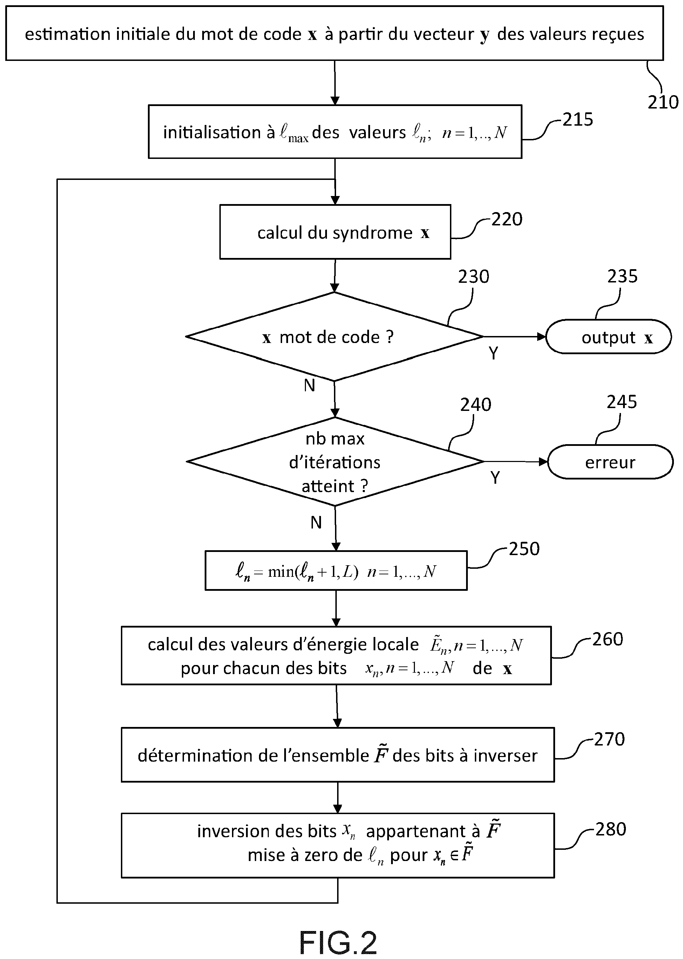

La Fig. 2 représente de manière schématique un ordinogramme d'une méthode de décodage d'un code LDPC selon le premier mode de réalisation de la présente invention.

A l'étape 210, on effectue une estimation initiale du mode de code **x** à partir d'un observable **y** représentatif du mot à décoder comme à étape 110. Comme précédemment, le vecteur **y** pourra être constitué de valeurs de LLRs et le mot binaire **x** être constitué des valeurs de signe correspondantes.

On initialise également à l'étape 215, le nombre $\ell_n$ d'itérations depuis la dernière inversion, pour chacun des bits, $x_n$, $n = 1,..., N$. Plus précisément, $\ell_n = L+1$, $n = 1, ..., N$.

On entre ensuite dans une boucle itérative, dans laquelle :
On calcule le syndrome de x en 220, soit $c_m$, $m = 1,...,M$.

En 230, on vérifie à partir du syndrome si **x** est un mot de code, c'est-à-dire si $c_m = +1$, $\forall m \in \{1,...,M\}$ ou, de

$$\sum_{m=1}^{M} c_m = M$$

manière équivalente, si            .

Si c'est le cas, l'algorithme de décodage fournit le mode de code **x** en 235.

En revanche, si le mot est erroné, on détermine en 240 si le nombre maximal d'itérations est atteint.

Dans l'affirmative, on génère une indication d'erreur en 245.

Dans la négative, on poursuit à l'étape 250 en incrémentant les valeurs $\ell_n$ de 1 sans dépasser toutefois la valeur *L*. Autrement dit, $\ell_n = \min(\ell_n + 1, L)$.

A l'étape 260, on calcule des valeurs d'énergie locale, $\tilde{E}_n$, $n = 1,..., N$, à partir de l'expression (6).

On détermine ensuite l'ensemble $\tilde{F}$ des bits les moins fiables à l'étape 270. L'ensemble $\tilde{F}$ est constitué des bits dont les valeurs d'énergie locale sont inférieures à une valeur de seuil $\tilde{E}_{th}$, calculée par exemple comme

$$\tilde{E}_{th} = \min_{n=1,..,N}\left(E_n\right) + \delta$$

, où $\delta \geq 0$ est une marge prédéterminée.

A l'étape 280, on inverse les bits de **x** appartenant à l'ensemble $\tilde{F}$ et l'on retourne à l'étape 220 pour une nouvelle itération.

L'homme du métier comprendra que le deuxième mode de réalisation diffère du premier en ce qu'à l'étape 270, les bits de l'ensemble $\tilde{F}$ ne sont pas systématiquement inversés mais le sont seulement avec une probabilité prédéterminée *p* comme indiqué plus haut.

De manière similaire, le troisième mode de réalisation diffère du premier en ce qu'à l'étape 260, pour déterminer si un bit appartient à l'ensemble $\tilde{F}$ on ajoute à l'énergie locale du bit un échantillon de bruit aléatoire, par exemple d'un bruit aléatoire gaussien de variance $\sigma^2$ avant de la comparer à la valeur de seuil, $\tilde{E}_{th}$.

Les éléments du vecteur représentatif de la composante inertielle, $\rho = (\rho(1), \rho(2),...,\rho(L))$ peuvent être déterminés de différentes manières.

Tout d'abord, les éléments du vecteur $\rho$ peuvent être déterminés par simulation de type Monte-Carlo de manière à optimiser les performances de correction d'erreurs de la méthode de décodage.

Alternativement, ils peuvent être obtenus par une méthode d'apprentissage par renforcement dans laquelle chaque état correspond à un vecteur $\rho$ (les éléments $\rho(1),\rho(2),...,\rho(L)$ sont supposés discrétisés), une récompense étant attribuée lorsque le décodage fournit un mot de code, la récompense pouvant être proportionnelle à la différence $P_{max} - P$ où $P_{max}$ est le nombre maximal d'itérations dans le critère d'arrêt et $P$ est le nombre d'itérations effectuées pour obtenir le mot de code.

Alternativement encore, on pourra procéder à une recherche exhaustive dans un espace restreint.

Plus précisément, si l'on remarque que $\tilde{E}_n = \tilde{E}_n + \rho(\ell_n)$ et si l'on suppose que les éléments du vecteur y sont discrétisés, c'est-à-dire prennent leurs valeurs dans l'ensemble $\{-Q_p,...,-Q_1,0,Q_1,...,Q_p\}$, la valeur de la fonction d'énergie locale $E_n$ associée à la variable $x_n$ est bornée par :

$$-\left(\alpha Q_p + d_v\right) \leq E_n \leq \alpha Q_p + d_v \qquad (7)$$

où $d_v$ est le degré maximal d'un noeud de variable dans le graphe de Tanner.

Si l'on suppose maintenant qu'au moins une équation de parité associée à un noeud de contrôle est insatisfaite (à défaut toutes les équations de parité seraient satisfaites et le mot serait un mot de code), il existe au moins un noeud de variable $x_n$ pour lequel :

$$E_n \leq \alpha Q_p + \left(d_v - 2\right) \tag{8}$$

dans la mesure où une erreur sur $x_n$ se traduit par une différence de 2 dans une valeur de $c_m$ , $m \in H(n)$.

Il en résulte que la valeur d'énergie minimale, $E_{\min} = \min\limits_{n=1,...,N}\left(E_n\right)$ vérifie également :

$$E_{\min} \leq \alpha Q_p + \left(d_v - 2\right) \tag{9}$$

Etant donné que la composante inertielle a pour objet d'augmenter l'énergie des bits qui ont été récemment inversés, on peut supposer que le minimum $E_{\min}$ est atteint pour un bit qui n'a pas été inversé lors des L dernières itérations, c'est-à-dire dont la composante inertielle est nulle $\rho(\ell) = 0$.

Il en résulte que la valeur de seuil $\tilde{E}_{th}$ vérifie :

$$\tilde{E}_{th} \leq \alpha Q_p + \left(d_v - 2\right) + \delta \tag{10}$$

Si l'on définit maintenant $\rho_{\max} = 2\alpha Q_p + (2d_v - 2) + \delta + \varepsilon$, on comprend que dès lors qu'un noeud de variable $x_n$ possède une valeur d'énergie locale $E_n$ avec une composante inertielle $\rho(\ell_n) \geq \rho_{\max}$ :

$$\tilde{E}_n = E_n + \rho\left(\ell_n\right) \geq \alpha Q_p + \left(d_v - 2\right) + \delta + \varepsilon > \tilde{E}_{th} \tag{11}$$

et donc que $x_n$ ne sera pas inversé au cours de l'itération courante.

On peut donc en conclure que $\rho(\ell) \leq \rho_{\max}$, $\ell=1,...,L$ dans la mesure où une valeur supérieure à $\rho_{\max}$ interdirait toute inversion d'un bit dès lors que le nombre d'itérations depuis sa dernière inversion serait égal à $\ell$.

Cette propriété permet de restreindre la recherche des valeurs possibles de $\rho(1),\rho(2),...,\rho(L)$ à une zone restreinte de $\left(\mathbb{R}^+\right)^N$ à savoir celle définie par :

$$\rho_{\max} \geq \rho(1) \geq \rho(2) \geq ... \geq \rho(L) > 0 \tag{12}$$

Ainsi, on pourra dans un premier temps fixer une valeur de L puis effectuer une recherche par force brute parmi les $L$-uplets $\rho(1),\rho(2),...,\rho(L)$ de valeurs discrétisées vérifiant (12) et conduisant au plus faible taux d'erreur. Alternativement, on pourra utiliser un algorithme génétique avec des opérations de mutation, combinaison et sélection des vecteurs $\rho$ pour rechercher celui correspondant au plus faible taux d'erreur.

Dans tous les cas cette optimisation des éléments de $\rho$ peut être réalisée une fois pour toutes hors ligne (*offline*).

Selon une autre approche, on pourra exprimer la composante inertielle $\rho(\ell)$ comme une fonction linéaire ou polynomiale du nombre $\ell$ d'itérations depuis la dernière inversion. Par exemple, dans le cas linéaire la composante inertielle aura la forme suivante:

$$\rho(\ell) = -a\ell + b, \ \ell = 1,..,L \tag{13}$$

avec $a,b > 0$. La valeur maximale, $\rho_{\max}$ , de la composante inertielle sera alors choisie telle que :

$$\rho_{\max} \geq \rho(1) = -a + b \tag{14-1}$$

et la valeur minimale de cette composante devra être positive, soit :

$$\rho(L) = -aL + b > 0 \tag{14-2}$$

En définitive, l'optimisation des éléments de $\rho$ se réduira à la recherche des paramètres $a,b$.

L'homme du métier sera à même d'envisager d'autres expressions paramétriques de $\rho(\ell)$ sans sortir du cadre de la présente invention. Ainsi, $\rho(\ell)$ pourra être recherchée comme une expression polynomiale décroissante sur $[1,L]$.

Pour des valeurs élevées de $L$, on pourra encore définir la fonction $\rho(\ell)$ par morceaux, par exemple comme une fonction linéaire voire constante par morceaux, auquel cas :

$$\rho(1) = ... = \rho(\ell_1) > \rho(\ell_1+1) = ... = \rho(\ell_2) > ... > \rho(\ell_s+1) = ... = \rho(L) > 0 \quad (15)$$

avec $1 < \ell_1 < \ell_2... < \ell_s < L$ définissent les bornes des intervalles en question.

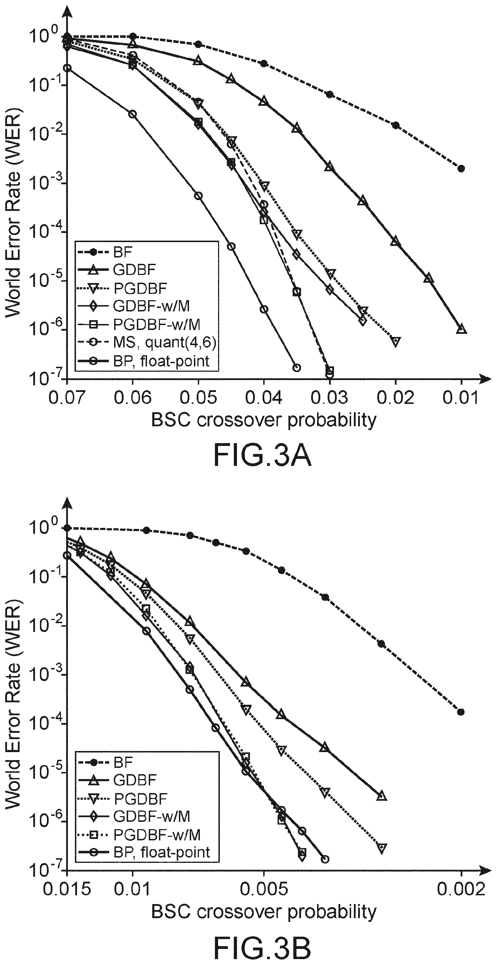

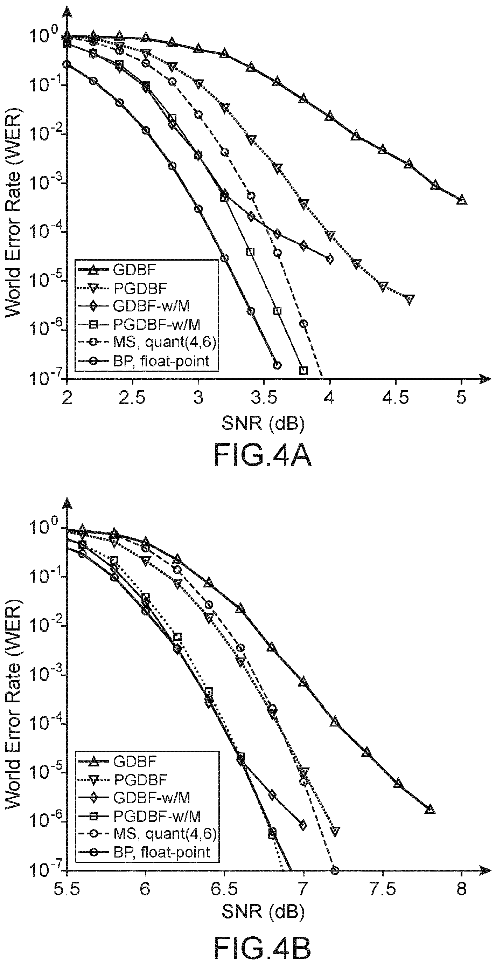

Les différences de performances entre la méthode de décodage de code LDPC selon la présente invention et celles connues de l'état de la technique sont illustrées au moyen des Figs 3A-3B et 4A-4B.

Le premier code LDPC était un code régulier (4,8), de taux $R = 0.5$, de longueur $N = 1296$ bits. On rappelle qu'un code est régulier lorsque tous les noeuds de variable ont le même degré, $d_v$, et que tous les noeuds de contrôle ont également le même degré, $d_c$ dans le graphe de Tanner. Les degrés des noeuds de variable et des noeuds de contrôle étaient respectivement $d_v = 4$ et $d_c = 8$.

Le second code LDPC était un code régulier (6,32), de taux $R = 0.84$, de longueur $N = 2048$ bits. Les degrés des noeuds de variable et des noeuds de contrôle étaient respectivement $d_v = 6$ et $d_c = 32$. Ce code est issu de la norme IEEE 802.3 an (Ethernet 10 Gbits/s sur paire torsadée).

Les méthodes de décodage connues de l'état de la technique ont été représentées sur les figures par leurs acronymes, à savoir :

BP, floating point : décodage par propagation de croyance, calcul en virgule flottante ;
MS, quant (4,6) : décodage au moyen de l'algorithme Min-Sum avec des messages de 4 bits ;
MS, floating point : décodage au moyen de l'algorithme Min-Sum, calcul en virgule flottante ;
BF : méthode originelle par inversion de bit (Gallager) ;
GDBF : méthode de décodage par inversion de bit à descente de gradient *(Gradient Descent Bit Flipping)* ;
PGDBF : méthode GDBF probabiliste *(Probabilistic Gradient Descent Bit Flipping)*.

Les exemples de méthode de décodage selon la présente invention sont représentés par :

GDBF-w/M : GDBF avec composante inertielle (with momentum)
PGDBF-w/M PGDBF avec composante inertielle (with momentum)

Dans le cas des Figs. 3A et 3B, on a supposé que le canal était binaire symétrique et l'on a représenté le taux d'erreur mot ou WER *(Word Error Rate)* en fonction de la probabilité de basculement d'un bit sur le canal *(BSC crossover probability)*.

Le coefficient de corrélation (méthodes GDBF/PGDBF avec ou sans inertie) a été choisi tel que $\alpha = 1.0$ pour le premier code LDPC et $\alpha = 2.0$ pour le second code LDPC.

La marge $\delta$ dans la valeur de seuil $\tilde{E}_{th}$ (méthodes GDBF/PGDBF avec ou sans inertie) a été choisie nulle que ce soit pour le premier ou le second code LDPC.

La probabilité d'inversion $p$ dans la méthode PGDBF et PGDBF-w/M a été choisie telle que $p = 0.9$ pour le décodage du premier code LDPC et $p = 0.8$ pour le décodage du second code LDPC.

Pour le décodage du premier code LDPC avec les méthodes GDBF-w/M et PGDBF-w/M, la composante inertielle était de dimension $L = 3$ avec $\rho = [4\ 2\ 1]$.

Pour le décodage du second code LDPC avec les méthodes GDBF-w/M et PGDBF-w/M, la composante inertielle était de dimension $L = 4$ avec $\rho = [4\ 3\ 2\ 1]$.

On remarque que l'introduction d'une composante inertielle améliore sensiblement les décodages GDBF et PGDBF. En outre, le décodage GDBF-w/M présente de meilleures performances que le décodage PGDBF, alors même que le premier ne fait pas appel à une randomisation pour l'inversion. En outre, le décodage PGDBF-w/M du premier ou du second code ne fait apparaître aucun plancher d'erreur jusqu'à des niveaux de WER de l'ordre de $10^{-7}$. Enfin, le décodage du second code LDPC par la méthode GDBF-w/M ou par la méthode PGDBF-w/M présentent des performances équivalentes, ces performances étant du même ordre, voire meilleures, que celles de la méthode par propagation de croyance BP dans la région du plancher d'erreur.

Dans le cas des Figs. 4A et 4B, on a supposé que le canal était de type AWGN (autrement dit affecté par un bruit blanc additif gaussien) et l'on a représenté le taux d'erreur mot ou WER *(Word Error Rate)*.

Le coefficient de corrélation (méthodes GDBF/PGDBF avec ou sans inertie) a été choisi tel que $\alpha = 1.8$ pour le premier code LDPC et $\alpha = 4.5$ pour le second code LDPC.

La marge $\delta$ dans la valeur de seuil $\tilde{E}_{th}$ (méthodes GDBF/PGDBF avec ou sans inertie) a été choisie égale à 1.1 pour le premier code LDPC et 1.2 pour le second code LDPC.

La probabilité d'inversion $p$ dans la méthode PGDBF et PGDBF-w/M a été choisie telle que $p = 0.9$ pour le décodage du premier code LDPC et $p = 0.8$ pour le décodage du second code LDPC.

Pour le décodage du premier code LDPC avec les méthodes GDBF-w/M et PGDBF-w/M, la composante inertielle était de dimension $L = 7$ avec $\rho = [2\ 2\ 2\ 2\ 2\ 1\ 1]$.

Pour le décodage du second code LDPC avec les méthodes GDBF-w/M et PGDBF-w/M, la composante inertielle était de dimension $L = 4$ avec $\rho = [3\ 3\ 2\ 1]$.

On remarque que les décodages GDBF-w/M et PGDBF-w/M présentent sensiblement les mêmes performances dans la zone de cascade (waterfall région) et dépassent même celles du décodage MS en virgule flottante même si le décodage GDBF-w/M est moins performant que le PGDBF-w/M dans la zone de plancher. Les performances du décodage PGDBF-w/M approchent (premier code LDPC) voire atteignent (second code LDPC) celles du décodage par propagation de croyance avec calcul en virgule flottante (BP floating-point).

De manière générale, les méthodes de décodage GDBF ou PGDBF avec composante inertielle permettent d'obtenir des performances (en termes de WER en fonction du rapport signal sur bruit) comparables à celles d'une méthode de décodage à propagation de croyance (BP) voire meilleures dans la zone de plancher d'erreur. Les méthodes de décodage selon l'invention sont donc particulièrement avantageuses dans les cas où le plancher d'erreur est très bas, c'est-à-dire lorsque le graphe de Tanner présente un degré de connectivité $d_c$ élevé.

## Revendications

1. Méthode de décodage d'un code LDPC représenté par un graphe de Tanner comprenant $N$ noeuds de variable et $M$ noeuds de contrôle, chaque noeud de contrôle étant associé à une contrainte de parité portant sur une pluralité de noeuds de variable, ladite méthode de décodage opérant sur un observable (**y**) représentatif du mot à décoder et procédant par itérations successives, chaque itération opérant sur un mot estimé (**x**) et, si le mot estimé n'est pas un mot du code, déterminant un ensemble ( $\tilde{F}$ ) des bits les moins fiables de ce mot pour être inversés avant l'itération suivante, les bits les moins fiables du mot estimé étant déterminés comme ceux dont la valeur d'une fonction d'énergie locale ($\tilde{E}_n$) est inférieure à une valeur de seuil, la fonction d'énergie locale d'un bit comprenant une première composante proportionnelle à la corrélation entre ce bit et un élément correspondant de l'observable, une deuxième composante représentative du nombre de contraintes non vérifiées dans lesquelles intervient ledit bit, ladite méthode étant **caractérisée en ce que** la fonction d'énergie locale comprend en outre une troisième composante, dite composante inertielle, décroissant avec le nombre ($\ell_n$) d'itérations effectuées depuis la dernière inversion de ce bit.

2. Méthode de décodage d'un code LDPC selon la revendication 1, **caractérisée en ce que** chaque bit de l'ensemble ($\tilde{F}$) des bits les moins fiables est inversé avant l'itération suivante.

3. Méthode de décodage d'un code LDPC selon la revendication 1, **caractérisée en ce que** chaque bit de l'ensemble ($\tilde{F}$) des bits les moins fiables est inversé avec une probabilité $p$ prédéterminée, $0 < p < 1$, avant l'itération suivante.

4. Méthode de décodage d'un code LDPC selon la revendication 1, **caractérisée en ce que** pour déterminer l'ensemble ($\tilde{F}$) des bits les moins fiables, on ajoute un bruit aléatoire de variance prédéterminée ($\sigma^2$) à la valeur de la fonction d'énergie locale ($\tilde{E}_n$) avant la comparaison avec ladite valeur de seuil.

5. Méthode de décodage d'un code LDPC selon la revendication 1, **caractérisée en ce que** la valeur de seuil est déterminée à partir de la valeur minimale de la fonction d'énergie locale sur les bits du mot estimée, augmentée d'une marge $\delta \geq 0$ prédéterminée.

6. Méthode de décodage d'un code LDPC selon l'une quelconque des revendications précédentes, **caractérisée en ce que** la valeur de seuil est adaptative et fonction du nombre total d'itérations effectuées depuis le début du décodage.

7. Méthode de décodage d'un code LDPC selon l'une quelconque des revendications précédentes, **caractérisée en ce que** la composante inertielle de la fonction d'énergie locale d'un bit est une fonction linéaire décroissante du nombre d'itérations effectuées depuis la dernière inversion de ce bit.

8. Méthode de décodage d'un code LDPC selon l'une quelconque des revendications 1 à 5, **caractérisée en ce que** la composante inertielle de la fonction d'énergie locale d'un bit est une fonction linéaire définie par morceaux.

9. Méthode de décodage d'un code LDPC selon l'une quelconque des revendications précédentes, **caractérisée en ce que** la composante inertielle de la fonction d'énergie locale d'un bit est nulle au-delà d'un nombre L d'itérations prédéterminé.

10. Méthode de décodage d'un code LDPC selon la revendication 9, **caractérisée** que, dans une étape d'initialisation, le nombre $\ell_n$ représentant le nombre d'itérations effectuées depuis la dernière inversion d'un bit est initialisé à une valeur $\ell_{max} \geq L$, ce nombre étant mis à zéro dès lors que ce bit est inversé, et incrémenté à chaque itération jusqu'à atteindre ladite valeur L.

**Patentansprüche**

1. Verfahren zum Decodieren eines LDPC-Codes, der durch einen Tanner-Graphen mit $N$ Variablenknoten und $M$ Kontrollknoten dargestellt wird, wobei jeder Kontrollknoten mit einer Paritätsbeschränkung verbunden ist, die sich auf eine Vielzahl von Variablenknoten bezieht, wobei das genannte Verfahren zum Decodieren mit einer Observablen (**y**)arbeitet, die für das zu decodierende Wort repräsentativ ist, und in aufeinanderfolgenden Iterationen vorgeht, wobei jede Iteration mit einem geschätzten Wort (**x**) arbeitet und, wenn das geschätzte Wort kein Wort des Codes ist, eine Menge ($\tilde{F}$) der unzuverlässigsten Bits dieses Wortes bestimmt, um vor der nächsten Iteration invertiert zu werden, wobei die am wenigsten zuverlässigen Bits des geschätzten Wortes als diejenigen bestimmt werden, deren Wert einer lokalen Energiefunktion ($\tilde{E}_n$) kleiner als ein Schwellwert ist, wobei die lokale Energiefunktion eines Bits eine erste Komponente, die proportional zur Korrelation zwischen diesem Bit und einem entsprechenden Element des Observablen ist sowie eine zweite Komponente, die repräsentativ für die Anzahl der nicht verifizierten Beschränkungen ist, in die das Bit eingreift, aufweist, wobei das Verfahren **dadurch gekennzeichnet ist, dass** die lokale Energiefunktion außerdem eine dritte Komponente, die sogenannte Trägheitskomponente, aufweist, die mit der Anzahl ($\ell_n$) der seit der letzten Inversion dieses Bits durchgeführten Iterationen abnimmt.

2. Verfahren zum Decodieren eines LDPC-Codes nach Anspruch 1, **dadurch gekennzeichnet, dass** jedes Bit des Satzes ($\tilde{F}$) der am wenigsten zuverlässigen Bits vor der nächsten Iteration invertiert wird.

3. Verfahren zum Decodieren eines LDPC-Codes nach Anspruch 1, **dadurch gekennzeichnet, dass** jedes Bit des Satzes ($\tilde{F}$) der unzuverlässigsten Bits vor der nächsten Iteration mit einer vorbestimmten Wahrscheinlichkeit $p$, mit $0 < p < 1$, invertiert wird.

4. Verfahren zum Decodieren eines LDPC-Codes nach Anspruch 1, **dadurch gekennzeichnet, dass** zur Bestimmung des Satzes ($\tilde{F}$) der weniger zuverlässigen Bits ein Zufallsrauschen mit vorbestimmter Varianz ($\sigma^2$) zu dem Wert der lokalen Energiefunktion ($\tilde{E}_n$) vor dem Vergleich mit dem genannten Schwellwert addiert wird.

5. Verfahren zum Decodieren eines LDPC-Codes nach Anspruch 1, **dadurch gekennzeichnet, dass** der Schwellwert aus dem Minimalwert der geschätzten lokalen Energiefunktion über die Wortbits, erhöht um eine vorbestimmte Marge $\delta \geq 0$, bestimmt wird.

6. Verfahren zum Decodieren eines LDPC-Codes nach einem der vorhergehenden Ansprüche, **dadurch gekennzeichnet, dass** der Schwellwert derart ausgebildet ist, dass er von der Gesamtzahl der seit dem Beginn des Decodierens durchgeführten Iterationen abhängt.

7. Verfahren zum Decodieren eines LDPC-Codes nach einem der vorhergehenden Ansprüche, **dadurch gekennzeichnet, dass** die Trägheitskomponente der lokalen Energiefunktion eines Bits eine linear abnehmende Funktion der Anzahl der Iterationen ist, die seit der letzten Inversion dieses Bits durchgeführt wurden.

8. Verfahren zum Decodieren eines LDPC-Codes nach einem der Ansprüche 1 bis 5, **dadurch gekennzeichnet, dass** die Trägheitskomponente der lokalen Energiefunktion eines Bits eine stückweise definierte lineare Funktion ist.

9. Verfahren zum Decodieren eines LDPC-Codes nach einem der vorhergehenden Ansprüche, **dadurch gekennzeichnet, dass** die Trägheitskomponente der lokalen Energiefunktion eines Bits jenseits einer vorbestimmten Anzahl L von Iterationen null ist.

10. Verfahren zum Decodieren eines LDPC-Codes nach Anspruch 9, **dadurch gekennzeichnet, dass** in einem Initialisierungsschritt die Zahl $\ell_n$, die die Anzahl der seit der letzten Inversion eines Bits durchgeführten Iterationen darstellt, auf einen Wert $\ell_{max} \geq L$ initialisiert wird, wobei diese Zahl auf Null gesetzt wird, sobald dieses Bit invertiert ist, und bei jeder Iteration inkrementiert wird, bis sie den Wert $L$ erreicht.

## Claims

1. Method for decoding an LDPC code represented by a Tanner graph comprising $N$ variable nodes and $M$ control nodes, each control node being associated with a parity constraint relating to a plurality of variable nodes, said decoding method operating on an observable (**y**) representing the word to be decoded and proceeding by successive iterations, each iteration operating on an estimated word (**x**) and, if the estimated word is not a code word, determining a set ($\tilde{F}$) of the least reliable bits of this word in order to be flipped before the following iteration, the least reliable bits of the estimated word being determined as those where the value of a local energy function ($\tilde{E}_n$) is less than a threshold value, the local energy function of a bit comprising a first component proportional to the correlation between this bit and a corresponding element of the observable, a second component representing the number of non-satisfied constraints in which said bit is involved, said method being **characterised in that** the local energy function further comprises a third component, referred to as an inertial component, decreasing with the number ($\ell_n$) of iterations performed since the last flipping of this bit.

2. Method for decoding an LDPC code according to claim 1, **characterised in that** each bit in the set ($\tilde{F}$) of least reliable bits is flipped before the following iteration.

3. Method for decoding an LDPC code according to claim 1, **characterised in that** each bit in the set ($\tilde{F}$) of least reliable bits is flipped with a predetermined probability $p$, $0 < p < 1$, before the following iteration.

4. Method for decoding an LDPC code according to claim 1, **characterised in that**, to determine the set ($\tilde{F}$) of least reliable bits, a random noise of predetermined variance ($\sigma^2$) is added to the value of the local energy function ($\tilde{E}_n$) before comparison with said threshold value.

5. Method for decoding an LDPC code according to claim 1, **characterised in that** the threshold value is determined from the minimum value of the local energy function on the bits of the estimated word, increased by a predetermined margin $\delta \geq 0$.

6. Method for decoding an LDPC code according to any one of the preceding claims, **characterised in that** the threshold value is adaptive and is a function of the total number of iterations implemented since the start of decoding.

7. Method for decoding an LDPC code according to any one of the preceding claims, **characterised in that** the inertial component of the local energy function of a bit is a decreasing linear function of the number of iterations implemented since the last flipping of this bit.

8. Method for decoding an LDPC code according to any one of claims 1 to 5, **characterised in that** the inertial component of the local energy function of a bit is a linear function defined piecewise.

9. Method for decoding an LDPC code according to any one of the preceding claims, **characterised in that** the inertial component of the local energy function of a bit is zero beyond a predetermined number L of iterations.

10. Method for decoding an LDPC code according to claim 9, **characterised in that**, in an initialisation step, the number $\ell_n$ representing the number of iterations implemented since the last flipping of a bit is initialised to a value $\ell_{max} \geq L$, this number being set to zero as soon as this bit is flipped, and incremented at each iteration until said value L is reached.

estimation initiale du mot de code $\mathbf{x}$ à partir du vecteur $\mathbf{y}$ des valeurs reçues

⌐110

calcul du syndrome $\mathbf{x}$ ⌐120

$\mathbf{x}$    mot de code ?    130   →   Y    output $\mathbf{x}$   135

N

nb max d'itérations atteint ?   140  →  Y    erreur   145

N

calcul des valeurs d'énergie locale   $E_n, n = 1, ..., N$   150
pour chacun des bits   $x_n, n = 1, ..., N$   de $\mathbf{x}$

détermination de l'ensemble $F$ des bits à inverser   160

inversion des bits de $\mathbf{x}$ appartenant à $F$   170

FIG.1

estimation initiale du mot de code **x** à partir du vecteur **y** des valeurs reçues

210

initialisation à $\ell_{\max}$ des valeurs $\ell_n$; $n = 1,.., N$ ⟋215

calcul du syndrome **x** ⟋220

230

**x** mot de code ?

235

output **x**

Y

N

240

nb max d'itérations atteint ?

245

erreur

Y

N

$\ell_n = \min(\ell_n + 1, L)$ $n = 1,..., N$ ⟋250

calcul des valeurs d'énergie locale $\tilde{E}_n, n = 1,..., N$ pour chacun des bits $x_n, n = 1,..., N$ de **x** ⟋260

détermination de l'ensemble $\tilde{F}$ des bits à inverser ⟋270

inversion des bits $x_n$ appartenant à $\tilde{F}$ mise à zéro de $\ell_n$ pour $x_n \in \tilde{F}$ ⟋280

## FIG.2

FIG.3A

FIG.3B

FIG.4A

FIG.4B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **R. GALLAGER.** Low density parity check codes. *IEEE Trans. Inform. Theory,* 1962, vol. IT-8, 21-28
- **T. WADAYAMA et al.** Gradient descent bit flipping algorithms for decoding LDPC codes. *IEEE Trans. on Comm.,* Juin 2010, vol. 58 (6), 1610-1614
- **O. AL RASHEED et al.** Fault-tolerant probabilistic gradient-descent bit flipping décoder. *IEEE Comm. Letters,* 2014, vol. 18 (9), 1487-1490
- **G. SUNDARARAJAN et al.** Noisy gradient descent bit-flip decoding for LDPC codes. *IEEE Trans. on Comm.,* 2014, vol. 62 (10), 3385-3400
- **H. CUI.** An improved gradient descent bit-flipping décoder for LDPC codes. *IEEE Trans. On Circuits and Systems,* 01 Août 2019, vol. 66 (8), 3188-3200
- **ZHANG LI et al.** Tabu-List Noisy Gradient Descent Bit Flipping Decoding of LDPC Codes. *Proc. 2019 11TH INTERNATIONAL CONFERENCE ON WIRELESS COMMUNICATIONS AND SIGNAL PROCESSING (WCSP),* 1-5
- Decoding LDPC codes via Noisy Gradient Descent Bit-Flipping with Re-Decoding. **TASNUVA TITHI et al.** ARXIV.ORG. CORNELL UNIVERSITY LIBRARY
- **CHANG TOFAR C-Y et al.** Multi-Stage Bit-Flipping Decoding Algorithms for LDPC Codes. *IEEE COMMUNICATIONS LETTERS,* vol. 23 (9
- **LI MAO-RUEI et al.** A modified gradient descent bit flipping decoding scheme for LDPC codes. *Proc. 2017 IEEE INTERNATIONAL WORKSHOP ON SIGNAL PROCESSING SYSTEMS (SIPS)*
- **DECLERCQ et al.** Noise-aided gradient descent bit-flipping decoders approaching maximum likelihood decoding. *Proc. 2016 9TH INTERNATIONAL SYMPOSIUM ON TURBO CODES AND ITERATIVE INFORMATION PROCESSING (ISTC)*
- **SUNDARARAJAN GOPALAKRISHNAN et al.** Noisy Gradient Descent Bit-Flip Decoding for LDPC Codes. *IEEE TRANSACTIONS ON COMMUNICATIONS,* vol. 62 (10